# FASCICULE DE BREVET EUROPEEN

(11) **EP 4 064 807 B1**
(45) Date de publication et mention de la délivrance du brevet: **29.03.2023**
(21) Numéro de dépôt: 22164351.3
(22) Date de dépôt: 25.03.2022
(51) Int. Cl.: H05K 7/14, H05K 7/20, F16B 2/06

(54) **DISPOSITIF DE REFROIDISSEMENT DE COMPOSANTS ÉLECTRONIQUES**
KÜHLVORRICHTUNG FÜR ELEKTRONISCHE KOMPONENTEN
DEVICE FOR COOLING ELECTRONIC COMPONENTS

(30) Priorité: 26.03.2021 FR 2103080
(43) Date de publication de la demande: 28.09.2022
(73) Titulaire: ALSTOM Holdings, 93400 Saint-Ouen-sur-Seine (FR)
(72) Inventeur: ZANETTI, Adrien, 69100 VILLEURBANNE (FR); TUYERAS, Gaetan, 38460 VEYSSILIEU (FR)
(74) Mandataire: Lavoix

(56) Documents cités:
- FR-A1- 2 886 508
- US-A1- 2007 253 169
- US-A1- 2014 328 616
- US-A1- 2017 257 966

## Description

La présente invention concerne un dispositif de refroidissement d'au moins une plaque de composants électroniques, comprenant :
- un bâti, comprenant au moins une fente de glissière destinée à recevoir un bord de la plaque, la fente de glissière étant délimitée par une face de verrouillage et une face de pression opposée à la face de verrouillage, et
- un dispositif de verrouillage destiné à maintenir en position la plaque dans le bâti.

Dans le domaine de l'électronique, il est essentiel d'assurer le refroidissement de composants électroniques afin d'optimiser le fonctionnement et de prolonger la durée de vie desdits composants.

De tels composants électroniques sont par exemple utilisés dans le domaine des transports et le bon refroidissement de ces composants est généralement critique pour assurer le bon fonctionnement d'un véhicule.

Dans le domaine du transport ferroviaire, on connait par exemple des dispositifs de refroidissement comprenant un boitier accueillant des plaques de composants électroniques. De telles plaques de composants électroniques génèrent de la chaleur qu'il est essentiel d'évacuer hors du boitier.

Il est connu d'utiliser des dispositifs de refroidissement afin de maintenir des plaques de composants électroniques dans un véhicule et d'assurer un bon transfert thermique entre de tels composants électroniques et l'extérieur du boitier. De tels dispositifs de refroidissement sont par exemple décrits dans le document US 2017/257966 A1. FR 2 886 508 A1 divulgue aussi un dispositif de refroidissement.

De tels dispositifs de refroidissement ne donnent toutefois pas entière satisfaction, ces dispositifs étant complexes à installer et coûteux à fabriquer.

Un des buts de l'invention est alors de proposer un dispositif de refroidissement facile à installer et peu coûteux.

A cet effet, l'invention a pour objet un dispositif de refroidissement conforme à la revendication 1.

Un dispositif de refroidissement comprenant un élément de maintien pouvant être amené dans sa configuration de maintien par simple flexion est particulièrement avantageux en raison de la simplicité à faire passer l'élément de maintien de sa configuration de libération à sa configuration de maintien, et inversement. Un tel dispositif de refroidissement s'avère en outre particulièrement peu onéreux à produire, notamment en raison du faible nombre de composants qu'il comporte.

Suivant d'autres aspects avantageux de l'invention, le dispositif de refroidissement comporte l'une ou plusieurs des caractéristiques des revendication 2 à 7, prise(s) isolément ou suivant toute combinaison techniquement possible.

L'invention sera mieux comprise à la lecture de la description qui va suivre, donnée uniquement à titre d'exemple non limitatif et faite en se référant aux figures suivantes, dans lesquelles :
[Fig 1] La figure 1 est une représentation schématique en perspective éclatée d'un dispositif de refroidissement comprenant un dispositif de verrouillage selon l'invention ;
[Fig 2] la figure 2 est une représentation schématique en coupe selon un plan de coupe médian du dispositif de refroidissement de la figure 1 lorsqu'il est monté ;
[Fig 3] la figure 3 est une représentation schématique en perspective d'un dispositif de verrouillage selon un premier mode de réalisation de l'invention;
[Fig 4] la figure 4 est une représentation schématique en perspective d'un élément de maintien du dispositif de verrouillage de la figure 4 présenté dans une configuration de maintien ; et
[Fig 5] la figure 5 est une représentation schématique en perspective d'un dispositif de verrouillage selon un deuxième mode de réalisation non revendiqué.

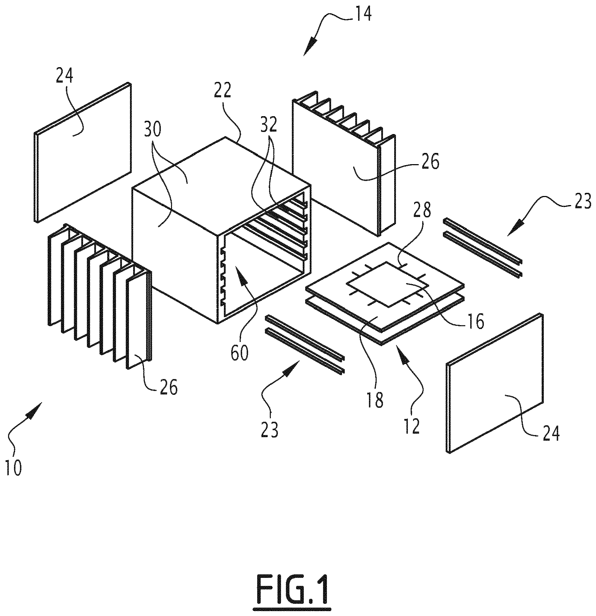

En référence à la figure 1, un véhicule (non représenté) comprend un système électronique 10.

Le véhicule est par exemple un véhicule ferroviaire tel un train à grande vitesse, un train régional, un tramway ou un métro. En variante, le véhicule est un véhicule routier tel un bus.

Le système électronique 10 comprend une plaque de composants électroniques 12, également appelée carte électronique, et un dispositif de refroidissement 14.

La plaque de composants électroniques 12 comprend au moins un composant électronique 16 et au moins un plateau conducteur de chaleur 18. La plaque de composants électroniques 12 comprend au moins un bord 20, s'étendant en périphérique de la plaque de composants électroniques 12. Le bord 20 est sensiblement plat et l'épaisseur du bord 20 est par exemple comprise entre 1 mm et 10 mm.

Le composant électronique 16 est par exemple une carte électronique telle un microprocesseur. Le composant électronique 16 est susceptible de générer de la chaleur. Le composant électronique 16 est par exemple rapporté sur le plateau conducteur de chaleur 18 et solidaire du plateau conducteur de chaleur 18.

Le plateau conducteur de chaleur 18 est par exemple un plateau formé en un matériau conducteur de chaleur, tel par exemple en aluminium. Le plateau conducteur de chaleur 18 est configuré pour conduire la chaleur générée par le composant électronique 16. Une portion du plateau conducteur de chaleur 18 forme de préférence le bord 20 de la plaque de composants électroniques 12.

Le dispositif de refroidissement 14 comprend un bâti 22 et un dispositif de verrouillage 23. Le dispositif de refroidissement 14 comprend de préférence au moins un couvercle 24, de préférence au moins un dissipateur thermique 26 et de préférence au moins un caloduc 28.

De préférence, le système électronique 10 comprend une carte électronique principale dite carte « mère » (non représentée) assemblée à un fond du dispositif de refroidissement 14 et propre à être recouverte par le couvercle 24. La carte électronique mère est propre à être connectée à plusieurs plaques de composants électroniques 12 formant des cartes électroniques secondaires dites cartes « filles ». La carte mère permet aux cartes filles de communiquer entre elles, et dispose de connecteurs de sortie pour communiquer avec l'extérieur.

Comme illustré en figure 1, le bâti 22 comprend une pluralité de parois 30. Dans l'exemple de la figure 1, le bâti 22 comprend quatre parois formant un parallélépipède définissant deux ouvertures sur deux faces opposées dudit parallélépipède.

Le bâti 22 comprend au moins une fente de glissière 32.

La fente de glissière 32 est destinée à recevoir un ou le bord 20 de la plaque de composants électroniques 12.

La fente de glissière s'étend par exemple dans l'une des parois 30 du bâti 22, et débouche sur un intérieur du bâti 22.

La fente de glissière 32 est délimitée par un fond 33. La distance entre le fond 33 de la fente de glissière 32 et une face intérieure 34 du bâti définit une profondeur p de fente de glissière.

La profondeur p de fente de glissière 32 est par exemple comprise entre 5mm et 50 mm.

La fente de glissière 32 est délimitée par une face de verrouillage 35 et une face de pression 36 opposée à la face de verrouillage 35. La face de pression 36 est de préférence parallèle à la face de verrouillage 35. Les faces de pression 36 et de verrouillage 35 connectent de préférence la face intérieure 34 du bâti au fond 33 de la fente de glissière 32. La face de pression 36 et la face de verrouillage 35 définissent entre elles une hauteur h de fente de glissière 32.

La hauteur h de fente de glissière 32 est de préférence comprise entre 5 mm et 30 mm. La hauteur h est supérieure à l'épaisseur du bord 20.

Dans l'exemple de la figure 1, le bâti 22 comprend une pluralité de paires de fentes de glissière 32. Chaque paire de fente de glissière 32 est formé par deux fentes de glissière 32 dont les faces de pression 36 et les faces de verrouillage 35 s'étendent selon un même plan respectif. Les deux fentes de glissière 32 d'une paire de fentes de glissière 32 s'étendent par exemple dans deux parois 30 du bâti 22 étant opposées l'une de l'autre.

Comme illustré en figure 1, une même plaque de composants électroniques 12 s'étend de préférence dans les deux fentes de glissière 32 d'une même paire de fentes de glissière 32.

Le dispositif de verrouillage 23 est destiné à maintenir en position la plaque de composants électroniques 12 dans le bâti 22.

Le dispositif de verrouillage 23 comporte un élément de maintien 38 et comprend de préférence un élément de verrouillage 40.

L'élément de maintien 38 est destiné à être logé dans la fente de glissière 32. L'élément de maintien 38 présente une forme générale allongée. L'élément de maintien 38 est par exemple allongé selon un axe longitudinal X-X' parallèle à une direction longitudinale définie par la fente de glissière 32, de sorte à ce que l'élément de maintien 38 s'étende longitudinalement dans la fente de glissière 32.

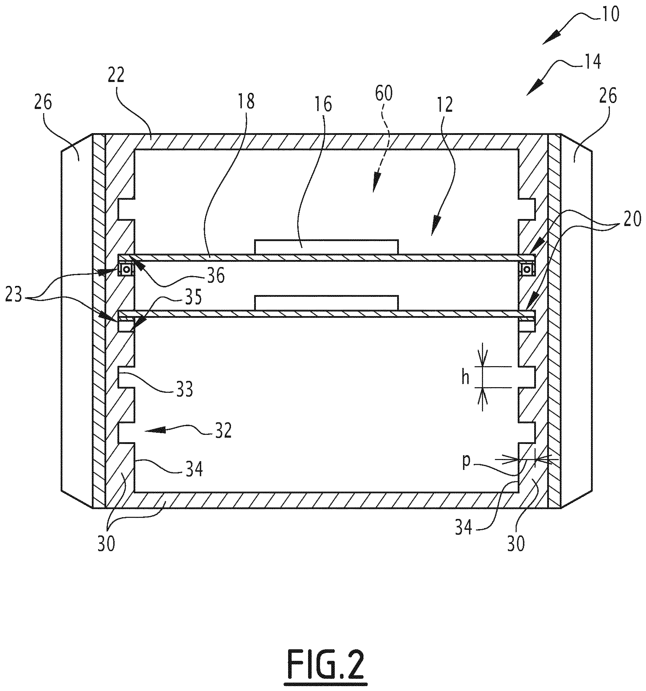

Comme illustré dans les figures 1 et 2, le dispositif de refroidissement comprend de préférence une pluralité de dispositifs de verrouillage 23, un dispositif de verrouillage 23 étant disposé dans chaque fente de glissière 32 du bâti. Un dispositif de verrouillage 23 est en particulier disposé dans chaque fente de glissière 32 d'une paire de fentes de glissières 32, les dispositifs de verrouillage étant destinés à maintenir en position deux bords 20 opposés de la plaque de composants électroniques 12.

L'élément de maintien 38 est flexible. La raideur angulaire en flexion de l'élément, de maintien 38, pour une déformation selon une direction perpendiculaire aux faces de pression 36 et de verrouillage 35 lorsque l'élément de maintien 38 est dans une fente de glissière 32, est de préférence comprise entre 0.1 N.m.rad⁻¹ et 50 N.m.rad⁻¹.

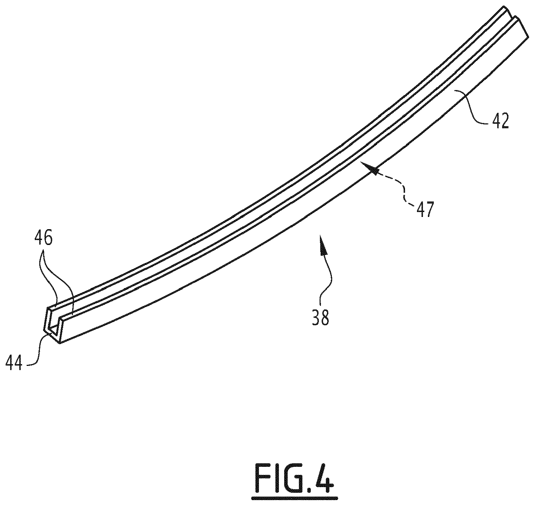

L'élément de maintien 38 présente une configuration de maintien, dans laquelle l'élément de maintien 38 est fléchi de manière à presser le bord 20 de la plaque de composants électroniques 12 contre la face de pression 36 lorsque la plaque 12 est insérée dans la fente de glissière 32. Une variante d'élément de maintien 38 dans sa configuration fléchie est illustré en figure 4.

Lorsqu'il est dans sa configuration de maintien, l'élément de maintien 38 est en appui, d'un côté, contre la face de verrouillage 35, et de l'autre côté contre le bord 20 de la plaque 12, de sorte qu'il presse le bord 20 de la plaque 12 contre la face de pression 36. En d'autres termes, le bord 20 de la plaque 12 est pris en sandwich entre la face de pression 36 et l'élément de maintien 38.

L'élément de maintien 38 présente une configuration de libération, dans laquelle l'élément de maintien 38 est redressé et permet un mouvement de la plaque 12 dans la fente de glissière 32 lorsque la plaque 12 est insérée dans la fente de glissière 32. Par redressé, on entend que l'élément de maintien 38 est sensiblement rectiligne selon la direction longitudinale.

Le bord 20 de la plaque 12 est disposé entre l'élément de maintien 38 et la face de de pression 36 et est mobile par rapport au bâti 22. La plaque 12 est par exemple mobile sensiblement en translation selon l'axe longitudinal X-X' par rapport à l'élément de maintien 38 et par rapport au bâti 22 permettant un démontage rapide de la plaque 12. Un jeu entre la face de pression 36, l'élément de maintien 38 et la plaque 12 permet par exemple le déplacement du bord de la plaque 12 par rapport à la face de pression 36 et l'élément de maintien 38. En d'autres termes, la somme de la hauteur de l'élément de maintien 38 additionnée à l'épaisseur du bord 20 de la plaque 12 est inférieure à la hauteur h de la fente, pour permettre le libre déplacement de la plaque 12 dans la glissière.

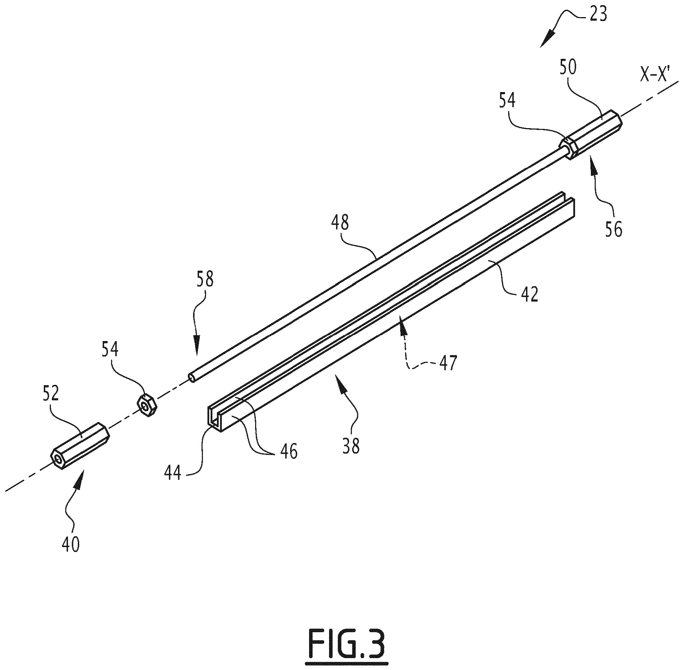

Dans la variante illustrée en figure 3, l'élément de maintien 38 est un profilé en U 42. Un tel élément de maintien 38 est en outre illustré maintenant la plaque de composants électroniques 12 du haut de la figure 2. Le profilé en U 42 s'étend selon l'axe longitudinal X-X'. Le profilé en U 42 comprend une base de profilé 44, la base de profilé 44 correspondant à un pan du profilé formant la base du U du profilé en forme de U 42, ainsi que des pattes 46 de profilé, s'étendant depuis la base pour former le profilé en forme de U. Le profilé en U 42 délimite un volume de profilé 47 s'étendant entre les pattes 46 du profilé.

L'élément de maintien 38 est de préférence une pièce d'extrusion dans un matériau conducteur tel que l'aluminium ou le cuivre, ou encore dans un acier ressort.

En variante de l'élément de maintien 38 de la figure 3, l'élément de maintien 38 possède une forme plus complexe permettant un flambage unidirectionnel. Par exemple, l'élément de maintien peut être un tube carré possédant des ouvertures supérieures. Selon cette variante, l'élément de maintien 38 retient directement une barre de maintien 48 de l'élément de verrouillage 23.

Lorsqu'il est dans sa configuration de maintien 44, le profilé en U formant l'élément de maintien 38 est fléchi perpendiculairement à la base de profilé 44, dans la même direction que les pattes de profilé 46, comme illustré sur la figure 4.

En référence à la figure 2, le bord 20 de la plaque de composants électroniques 12 est serré entre la base de profilé 44 et la face de pression 36 lorsque le profilé en U formant l'élément de maintien 38 est dans sa configuration de maintien, les pattes 46 du profilé en U étant en appui contre la face de verrouillage 35.

L'élément de verrouillage 40 est mobile entre une position de déverrouillage et une position de verrouillage.

Lorsqu'il est dans sa position de verrouillage, l'élément de verrouillage 40 maintient l'élément de maintien 38 dans sa configuration de maintien.

Lorsqu'il est dans sa position de déverrouillage, l'élément de verrouillage 40 laisse l'élément de maintien 38 dans sa configuration de libération.

L'élément de verrouillage 40 est relié à l'élément de maintien 38 de sorte que l'élément de verrouillage 40 entraine l'élément de maintien 38 vers sa configuration de maintien lorsqu'il passe de sa position de déverrouillage à sa position de verrouillage et de sorte que l'élément de verrouillage 40 entraine l'élément de maintien 38 vers sa configuration de libération lorsqu'il passe de sa position de verrouillage à sa position de déverrouillage.

Dans la variante de la figure 3, l'élément de verrouillage 40 comprend une barre de verrouillage 48, un organe de blocage 50 et un organe de serrage 52. L'élément de verrouillage comprend par exemple au moins une entretoise 54.

La barre de verrouillage 48 s'étend sensiblement parallèlement à l'axe longitudinal X-X'. La barre de verrouillage 48 s'étend par exemple dans le volume de profilé 47.

La barre de verrouillage 48 comprend une première extrémité 56 et une deuxième extrémité 58. La première extrémité 56 et la deuxième extrémité 58 de la barre de verrouillage 48 sont par exemple filetées.

Avantageusement, l'élément de maintien 38 comprend un poinçonnage/emboutissage propre à maintenir la barre de verrouillage 48 du dispositif de verrouillage 23 dans l'élément de maintien 38 lorsque ce dernier est manipulé ou encore en configuration de verrouillage. Cela évite que la barre de verrouillage 48 s'écarte de l'élément de maintien 38 et que la barre de verrouillage 48 sorte par exemple du volume de profilé 47.

L'organe de blocage 50 est disposé à la première extrémité 56 de la barre de verrouillage 48. L'organe de blocage 50 est configuré pour être immobile par rapport à la barre de verrouillage 48 lorsqu'un effort est appliqué suivant l'axe longitudinal X-X' sur l'organe de blocage 50.

L'organe de blocage 50 est par exemple vissé sur la première extrémité 56 de la barre de verrouillage 48.

L'organe de serrage 52 est disposé à la deuxième extrémité 58 de la barre de verrouillage 48. L'organe de serrage 52 est déplaçable longitudinalement relativement à la barre de verrouillage 48, pour déplacer l'élément de verrouillage 40 entre ses positions de déverrouillage et de verrouillage. La position de l'élément de verrouillage 40 est en particulier déterminée par l'écart entre l'organe de serrage 52 et l'organe de blocage 50. La position de déverrouillage correspondant à une position de l'organe de serrage 52 relativement à l'organe de blocage 50 dans laquelle l'écart entre l'organe de blocage 50 et l'organe de serrage 52 est plus grande que ledit écart, lorsque l'élément de verrouillage 40 est dans une position de verrouillage.

L'organe de serrage 52 est par exemple vissé sur la deuxième extrémité 58 de la barre de verrouillage 48. L'élément de verrouillage 40 est par exemple mobile entre ses positions de verrouillage et déverrouillage respectivement par vissage, dévissage, de l'organe de serrage 52 sur la barre de verrouillage 48.

L'écart entre l'organe de serrage 52 et l'organe de blocage 50 lorsque l'élément de verrouillage 40 est dans sa position de déverrouillage est par exemple supérieur à la longueur longitudinale du profilé en U 42 lorsque le profilé en U formant l'élément de maintien 38 est dans sa configuration de libération. Le profilé en U est alors libre entre l'organe de serrage 52 et l'organe de blocage 50, le profilé en U 42 étant dans une position redressée dans laquelle il est sensiblement rectiligne selon l'axe longitudinal X-X'.

L'écart entre l'organe de serrage 52 et l'organe de blocage 50 lorsque l'élément de verrouillage 40 est dans sa position de verrouillage est par exemple inférieur à la longueur longitudinale du profilé en U 42 lorsque le profilé en U formant l'élément de maintien 38 est dans sa configuration de maintien. Lorsque l'élément de verrouillage 48 est dans sa position de verrouillage, le profilé en U 42 est serré longitudinalement entre l'organe de serrage 52 et l'organe de blocage 50, le serrage longitudinal du profilé en U 42 entrainant la flexion dudit profilé en U perpendiculairement à l'axe longitudinal X-X'.

L'entretoise 54 est par exemple disposée entre l'organe de blocage 50 et le profilé en U 42. En alternative, ou en complément, l'entretoise 54 est disposée entre l'organe de serrage 52 et le profilé en U 42.

L'entretoise 54 est par exemple configurée pour autoriser une rotation de l'organe de serrage 52 et/ou de l'organe de blocage 50 tout en distribuant l'effort de serrage longitudinal exercé par l'organe de serrage 52 et de l'organe de blocage 50 aux extrémités du profilé en U 42. L'entretoise 54 est par exemple lisse et permet par exemple de contenir les frottements de vissage entre l'organe de serrage 52 et le profilé 42 en U.

Le caloduc 28 est disposé sur la plaque de composants électroniques 12. Le caloduc fait par exemple partie de la plaque de composants électroniques 12. Le caloduc 28 connecte électriquement au moins un ou le composant électronique 16 au tronçon conducteur de chaleur 18.

Le couvercle 24 est configuré pour être fixé sur le bâti 22. Dans l'exemple de la figure 1, le dispositif de refroidissement 14 comprend deux couvercles fixés sur le bâti 22.

L'au moins un couvercle 24 et le bâti définissent ensemble un volume intérieur 60 étanche lorsque le ou chaque couvercle 24 est fixé au bâti 22. Chaque couvercle 24 s'étend par exemple en regard d'une ouverture du bâti 22 pour fermer le bâti 22 et définir ensemble le volume intérieur étanche 60.

Comme illustré sur la figure 1, l'au moins un dissipateur thermique 26 s'étend hors du volume intérieur. L'au moins un dissipateur thermique 26 est fixé au bâti 22 et/ou au couvercle 24.

L'au moins un dissipateur thermique 26 est configuré pour dissiper la chaleur transmise par le bâti 22 vers un extérieur du bâti.

L'au moins un dissipateur thermique 26 est par exemple un dissipateur à ailettes tel que représenté en figure 1. En variante ou en complément, au moins un dissipateur thermique 26 est un dissipateur à liquide (non représenté).

Une brève description de la mise en place et du fonctionnement d'un dispositif de refroidissement tel que décrit plus haut va maintenant être présenté.

Un dispositif de refroidissement 14 tel que précité est fourni, les dispositifs de verrouillage disposés dans une paire de fentes de glissière 32 étant fournis avec leurs éléments de maintien 38 dans une configuration de libération et leurs éléments de verrouillage 40 dans une position de déverrouillage, le ou les couvercle(s) 24 étant disposé(s) à l'écart du bâti 22.

Une plaque de composants électroniques 12 est alors insérée dans chacune des fentes de glissières 32 de la paire de fente de glissière 32. Les bords 20 de la plaque de composants électroniques 12 sont glissés entre l'élément de maintien 38 et la face de pression 36 dans chacune des fentes de glissière 32 de la paire de fentes de glissière 32.

L'élément de verrouillage 40 est alors déplacé de sa position de déverrouillage à sa position de verrouillage pour amener l'élément de maintien de sa configuration de libération à sa configuration de maintien.

L'élément de maintien 38 dans sa configuration de maintien est fléchi de sorte à plaquer les bords 20 de la plaque de composants électroniques 12 sur la face de pression 36.

Le ou chaque couvercle 24 est ensuite fixé sur le bâti 22 de sorte à définir le volume intérieur étanche 60.

Avantageusement, le montage/démontage et le maintien de la plaque de composants 12 s'effectue par l'accès aux couvercles 24.

En fonctionnement, la chaleur générée par chaque composant électronique 16 est conduite dans la plaque 12. La plaque 12 est pressée contre la face de pression 36 de sorte que la chaleur soit conduite depuis la plaque 12 vers le bâti 22. La chaleur est ensuite de préférence transmise par conduction du bâti à au moins un dissipateur pour dissiper la chaleur à l'extérieur du bâti.

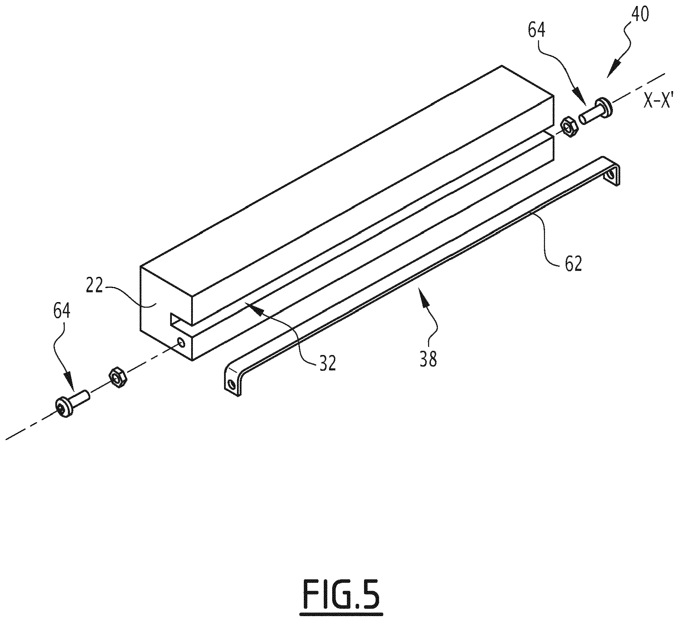

Le mode de réalisation présenté ci-après, non revendiqué, et en référence avec la figure 5, diffère du mode de réalisation présenté précédemment uniquement par les éléments qui suivent. Les éléments analogues portent les mêmes références.

Ce mode de réalisation propose d'intégrer l'élément de maintien 38 dans le bâti 22 pour réduire le nombre de pièce et rendre le dispositif plus compact. Il permet aussi d'effectuer un verrouillage par l'une ou l'autre des extrémités de l'élément de maintien 38.

L'élément de maintien 38 comprend une barre plate 62 d'axe longitudinal X-X' à la place d'un profilé en U 42. Un tel élément de maintien 38 est en outre illustré maintenant au niveau la plaque de composants électroniques 12 du bas de la figure 2

L'élément de verrouillage 40 comprend au moins deux organes de fixation 64 à la place d'une barre de verrouillage 48, d'un organe de blocage 50 et d'un organe de serrage 42.

Chaque organe de fixation 64 est configuré pour être vissé dans le bâti 22 pour déplacer l'élément de verrouillage 40 entre ses positions de déverrouillage et de verrouillage.

La barre plate 62 est serrée longitudinalement entre les deux organes de fixation 64 lorsque l'élément de verrouillage 40 est dans sa position de verrouillage, le serrage longitudinal de la barre plate 62 entrainant la flexion de ladite barre plate 62.

La barre plate 62 est une pièce venue de matière, par exemple une tôlerie avantageusement dans un matériau conducteur tel qu'un acier ressort.

La barre plate 62 comprend par exemple un tronçon principal et deux tronçons d'extrémités, le tronçon principal étant relié en ses extrémités aux deux tronçons d'extrémité par deux plis. Les tronçons principaux s'étendent par exemple sensiblement perpendiculairement au tronçon principal.

Chaque tronçon d'extrémité comprend par exemple une région d'accueil d'un organe de fixation 64, la barre plate 62 étant ainsi configurée pour accueillir les organes de fixation 64. L'organe de fixation 64 est par exemple une vis destinée à être vissée dans le bâti 22 et à passer au travers de la barre plate 62. L'organe de fixation 64 est configuré pour rapprocher les deux extrémités de la barre plate 62 de manière à fléchir la barre plate 62.

La barre plate 62 est de préférence réalisée par des procédés de tôlerie simples tels que le pliage et l'emboutissage.

La barre plate 62 est sensiblement plus longue que la profondeur du bâti 22, afin de rendre mobiles les extrémités de la barre plane l'une par rapport à l'autre et de déplacer l'élément de maintien 38 entre ses configurations de maintien et de libération.

## Revendications

1. Dispositif de refroidissement (14) d'au moins une plaque de composants électroniques (12), comprenant :
- un bâti (22), comprenant au moins une fente de glissière (32) destinée à recevoir un bord (20) de la plaque (12), la fente de glissière (32) étant délimitée par une face de verrouillage (35) et une face de pression (36) opposée à la face de verrouillage (35),
- un dispositif de verrouillage (23) destiné à maintenir en position la plaque (12) dans le bâti (22),
le dispositif de verrouillage (23) comportant un élément de maintien (38) destiné à être logé dans la fente de glissière (32), l'élément de maintien (38) étant flexible et présentant de préférence une forme générale allongée, l'élément de maintien (38) présentant une configuration de maintien, dans laquelle l'élément de maintien (38) est fléchi de manière à presser le bord (20) de la plaque (12) contre la face de pression (36) lorsque le bord de la plaque (12) est reçu dans la fente de glissière (32), et une configuration de libération dans laquelle l'élément de maintien (38) est redressé et permet un mouvement de la plaque (12) dans la fente de glissière (32),
le dispositif de verrouillage (23) comportant un élément de verrouillage (40) relié à l'élément de maintien (38), et mobile entre une position de déverrouillage et une position de verrouillage, de sorte que l'élément de verrouillage (40) entraine l'élément de maintien (38) vers sa configuration de maintien lorsqu'il passe de sa position de déverrouillage à sa position de verrouillage, et entraine l'élément de maintien (38) vers sa configuration de libération lorsqu'il passe de sa position de verrouillage à sa position de déverrouillage, et
**caractérisé en ce que** l'élément de maintien comprend :
- un profilé en U (42) d'axe longitudinal (X-X'), délimitant un volume de profilé (47);
et dans lequel l'élément de verrouillage (40) comprend:
- une barre de verrouillage (48) s'étendant dans le volume de profilé (47),
- un organe de blocage (50), disposé à une première extrémité (56) de la barre de verrouillage (48), et
- un organe de serrage (52), disposé à une deuxième extrémité (58) de la barre de verrouillage (48),
l'organe de serrage (52) étant déplaçable longitudinalement relativement à la barre de verrouillage (48), pour déplacer l'élément de verrouillage (40) entre ses positions de déverrouillage et de verrouillage, le profilé en U (42) étant serré longitudinalement entre l'organe de serrage (52) et l'organe de blocage (50) lorsque l'élément de verrouillage (40) est dans sa position de verrouillage, le serrage longitudinal du profilé en U (42) entrainant la flexion dudit profilé en U.

2. Dispositif de refroidissement (14) selon la revendication 1, dans lequel la première (56) et la deuxième (58) extrémités de la barre de verrouillage (48) sont filetées, l'organe de blocage (50), respectivement l'organe de serrage (52), étant vissés sur la première (56), respectivement la deuxième (58), extrémités de la barre de verrouillage (48).

3. Dispositif de refroidissement (14) selon la revendication 1 ou 2, dans lequel l'élément de verrouillage (40) comprend au moins une entretoise (54) disposée entre l'organe de blocage (50) et le profilé en U (42) et/ou au moins une entretoise (54) disposée entre l'organe de serrage (52) et le profilé en U (42).

4. Dispositif de refroidissement (14) selon l'une quelconque des revendications précédentes, dans lequel le bâti (22) comprend une pluralité de paires de fentes de glissières (32), chaque paire de fente de glissière (32) étant formée par deux fentes de glissières (32) dont les faces de verrouillage (35) et les faces de pression (36) s'étendent selon un même plan respectif, le dispositif de refroidissement (14) comprenant un dispositif de verrouillage (23) disposé dans chaque fente de glissière (32), une même plaque de composants électroniques (12) s'étendant dans les fentes de glissière (32) d'une même paire de fentes de glissière (32).

5. Dispositif de refroidissement (14) selon l'une quelconque des revendications précédentes, dans lequel le dispositif de refroidissement (14) comprend au moins un caloduc (28), la plaque de composants électroniques (12) comprenant au moins un composant électronique (16) et un plateau conducteur de chaleur (18), l'au moins un composant électronique (16) étant thermiquement connectée au plateau conducteur de chaleur (18) par au moins un caloduc (28).

6. Dispositif de refroidissement (14) selon l'une quelconque des revendications précédentes, dans lequel le dispositif de refroidissement (14) comprend au moins un couvercle (24) configuré pour être fixé sur le bâti (22), l'au moins un couvercle (24) et le bâti (22) définissant ensemble un volume intérieur (60) étanche lorsque le ou chaque couvercle (24) est fixé au bâti (22).

7. Dispositif de refroidissement (14) selon la revendication 6, dans lequel le dispositif de refroidissement (14) comprend au moins un dissipateur thermique (26), l'au moins un dissipateur thermique (26) s'étendant hors du volume intérieur (60) et étant fixé au bâti (22) et/ou au couvercle (24).

## Patentansprüche

1. Vorrichtung zum Kühlen (14) mindestens einer Platte elektronischer Komponenten (12), umfassend:
- ein Gestell (22), umfassend mindestens einen Führungsschlitz (32) zum Aufnehmen eines Rand (20) der Platte (12), wobei der Führungsschlitz (32) durch eine Verriegelungsfläche (35) und eine Druckfläche (36) gegenüber der Verriegelungsfläche (35) begrenzt ist,
- eine Verriegelungsvorrichtung (23), die dazu dient, die Platte (12) in dem Gestell (22) in Position zu halten,
die Verriegelungsvorrichtung (23) umfassend ein Halteelement (38) zum Aufnehmen in dem Führungsschlitz (32), wobei das Halteelement (38) flexibel ist und vorzugsweise eine allgemein längliche Form aufweist, wobei das Halteelement (38) eine Haltekonfiguration, in der das Halteelement (38) gebogen ist, um den Rand (20) der Platte (12) gegen die Druckfläche (36) zu drücken, wenn der Rand der Platte (12) in dem Führungsschlitz (32) aufgenommen ist, und eine Freigabekonfiguration, in der das Halteelement (38) aufgerichtet ist und eine Bewegung der Platte (12) in dem Führungsschlitz (32) zulässt, aufweist,
die Verriegelungsvorrichtung (23) umfassend ein Verriegelungselement (40), das mit dem Halteelement (38) verbunden ist und zwischen einer Entriegelungsposition und einer Verriegelungsposition beweglich ist, sodass das Verriegelungselement (40) das Halteelement (38) in seine Haltekonfiguration treibt, wenn es von seiner Entriegelungsposition in seine Verriegelungsposition bewegt wird, und das Halteelement (38) in seine Freigabekonfiguration treibt, wenn es von seiner Verriegelungsposition in seine Entriegelungsposition bewegt wird, und
**dadurch gekennzeichnet ist, dass** das Halteelement Folgendes umfasst:
- ein U-Profil (42) mit einer Längsachse (X-X'), das ein Profilvolumen (47) begrenzt; und wobei das Verriegelungselement (40) Folgendes umfasst:
- eine Verriegelungsstange (48), die sich in das Profilvolumen (47) erstreckt,
- ein Blockierelement (50), das an einem ersten Ende (56) der Verriegelungsstange (48) angeordnet ist, und
- ein Klemmelement (52), das an einem zweiten Ende (58) der Verriegelungsstange (48) angeordnet ist,
wobei das Klemmelement (52) in Längsrichtung in Bezug auf die Verriegelungsstange (48) verschiebbar ist, um das Verriegelungselement (40) zwischen seiner Entriegelungsposition und seiner Verriegelungsposition zu bewegen, wobei das U-Profil (42) in Längsrichtung zwischen dem Klemmelement (52) und dem Blockierelement (50) eingeklemmt wird, wenn das Verriegelungselement (40) in seiner Verriegelungsposition ist, wobei das Einklemmen des U-Profils (42) in Längsrichtung die Biegung des U-Profils bewirkt.

2. Kühlvorrichtung (14) nach Anspruch 1, wobei das erste (56) und das zweite (58) Ende der Verriegelungsstange (48) mit Gewinde versehen sind, wobei das Blockierelement (50) bzw. das Klemmelement (52) auf das erste (56) bzw. das zweite (58) Ende der Verriegelungsstange (48) aufgeschraubt ist.

3. Kühlvorrichtung (14) nach Anspruch 1 oder 2, wobei das Verriegelungselement (40) mindestens einen Abstandhalter (54) umfasst, der zwischen dem Klemmelement (50) und dem U-Profil (42) angeordnet ist, und/oder mindestens einen Abstandhalter (54), der zwischen dem Klemmelement (52) und dem U-Profil (42) angeordnet ist.

4. Kühlvorrichtung (14) nach einem der vorherigen Ansprüche, wobei das Gestell (22) eine Vielzahl von Paaren von Führungsschlitzen (32) umfasst, wobei jedes Paar von Führungsschlitzen (32) durch zwei Führungsschlitze (32) gebildet ist, deren Verriegelungsflächen (35) und Druckflächen (36) sich in einer jeweils gleichen Ebene erstrecken, die Kühlvorrichtung (14) umfassend eine Verriegelungsvorrichtung (23), die in jedem Führungsschlitz (32) angeordnet ist, wobei sich eine gleiche Platte elektronischer Komponenten (12) in die Führungsschlitz (32) eines gleichen Paars von Führungsschlitz (32) erstreckt.

5. Kühlvorrichtung (14) nach einem der vorherigen Ansprüche, wobei die Kühlvorrichtung (14) mindestens ein Wärmerohr (28) umfasst, wobei die Platte elektronischer Komponenten (12) mindestens eine elektronische Komponente (16) und eine wärmeleitende Platte (18) umfasst, wobei die mindestens eine elektronische Komponente (16) durch mindestens ein Wärmerohr (28) thermisch mit der wärmeleitenden Platte (18) verbunden ist.

6. Kühlvorrichtung (14) nach einem der vorherigen Ansprüche, wobei die Kühlvorrichtung (14) mindestens einen Deckel (24) umfasst, der konfiguriert ist, um an dem Gestell (22) befestigt zu werden, wobei der mindestens eine Deckel (24) und das Gestell (22) zusammen ein abgedichtetes Innenvolumen (60) definieren, wenn der oder jeder Deckel (24) an dem Gestell (22) befestigt ist.

7. Kühlvorrichtung (14) nach Anspruch 6, wobei die Kühlvorrichtung (14) mindestens einen Kühlkörper (26) umfasst, wobei sich der mindestens eine Kühlkörper (26) aus dem Innenvolumen (60) erstreckt und an dem Gestell (22) und/oder dem Deckel (24) befestigt ist.

## Claims

1. Device for cooling (14) at least one electronic component board (12), comprising:
- a frame (22), comprising at least one slide slot (32) for receiving an edge (20) of the plate (12), the slide slot (32) being defined by a locking face (35) and a pressure face (36) opposite the locking face (35),
- a locking device (23) for holding the plate (12) in position in the frame (22),
the locking device (23) having a holding member (38) for receipt in the slide slot (32), the holding member (38) being flexible and preferably having a generally elongate shape, the holding member (38) having a holding configuration in which the holding member (38) is flexed to press the edge (20) of the plate (12) against the pressure face (36) when the edge of the plate (12) is received in the slide slot (32), and a release configuration in which the holding member (38) is straightened and allows movement of the plate (12) in the slide slot (32),
the locking device (23) having a locking member (40) connected to the holding member (38), and movable between an unlocked position and a locked position, such that the locking member (40) drives the holding member (38) to its holding configuration when it moves from its unlocked position to its locked position, and drives the holding member (38) to its release configuration when it moves from its locked position to its unlocked position; and
**characterised in that** the holding element comprises:
- a U-shaped profile (42) of longitudinal axis (X-X'), defining a profile volume (47); and wherein the locking element (40) comprises:
- a locking bar (48) extending into the profile space (47),
- a blocking member (50) at a first end (56) of the locking bar (48), and
- a clamping member (52), arranged at a second end (58) of the locking bar (48),
the clamping member (52) being longitudinally movable relative to the locking bar (48), to move the locking element (40) between its unlocked and locked positions, the U-shaped profile (42) being clamped longitudinally between the clamping member (52) and the blocking member (50) when the locking element (40) is in its locked position, the longitudinal clamping of the U-shaped profile (42) causing the channel to flex.

2. Cooling device (14) according to claim 1, wherein the first (56) and second (58) ends of the locking bar (48) are threaded, the locking member (50), respectively the clamping member (52), being screwed to the first (56), respectively the second (58), ends of the locking bar (48).

3. Cooling device (14) according to claim 1 or 2, wherein the locking element (40) comprises at least one spacer (54) arranged between the locking member (50) and the U-profile (42) and/or at least one spacer (54) arranged between the clamping member (52) and the U-profile (42).

4. A cooling device (14) according to any one of the preceding claims, wherein the frame (22) comprises a plurality of pairs of slide slots (32), each pair of slide slots (32) being formed by two slide slots (32) whose locking faces (35) and pressure faces (36) extend in a respective same plane, the cooling device (14) comprising a locking device (23) disposed in each slide slot (32), a same electronic component board (12) extending into the slide slots (32) of a same pair of slide slots (32).

5. A cooling device (14) according to any one of the preceding claims, wherein the cooling device (14) comprises at least one heat pipe (28), the electronic component board (12) comprising at least one electronic component (16) and a heat conductive plate (18), the at least one electronic component (16) being thermally connected to the heat conductive plate (18) by at least one heat pipe (28).

6. A cooling device (14) according to any one of the preceding claims, wherein the cooling device (14) comprises at least one cover (24) configured to be attached to the frame (22), the at least one cover (24) and the frame (22) together defining a sealed interior volume (60) when the or each cover (24) is attached to the frame (22).

7. The cooling device (14) according to claim 6, wherein the cooling device (14) comprises at least one heat sink (26), the at least one heat sink (26) extending out of the interior volume (60) and being attached to the frame (22) and/or the cover (24).
